# FASCICULE DE BREVET EUROPEEN

(11) **EP 1 324 385 B1**
(45) Date de publication et mention de la délivrance du brevet: **23.05.2012**
(21) Numéro de dépôt: 02293182.8
(22) Date de dépôt: 20.12.2002
(51) Int. Cl.: H01L 21/18, H01L 21/20, H01L 21/762, H01L 29/12

(54) **Procédé de report de couches minces semi-conductrices à partir d'une plaquette donneuse.**
Verfahren zum Übertragen von Halbleiter-Dünnschichten aus einer Dünnschicht-Quelle.
Process for transfering semiconductor thin layers from a donor wafer.

(30) Priorité: 21.12.2001 FR 0116713
(43) Date de publication de la demande: 02.07.2003
(73) Titulaire: Soitec, 38190 Bernin (FR)
(72) Inventeur: Letertre, Fabrice, 38000 Grenoble (FR); Maurice, Thibaut, 38000 Grenoble (FR)
(74) Mandataire: Le Forestier, Eric

(56) Documents cités:
- DE-A- 19 943 101
- US-A- 6 010 579
- US-B1- 6 326 279
- PATENT ABSTRACTS OF JAPAN vol. 014, no. 471 (E-0990), 15 octobre 1990 (1990-10-15) -& JP 02 194519 A (NIPPON TELEGR & TELEPH CORP), 1 août 1990 (1990-08-01)
- PATENT ABSTRACTS OF JAPAN vol. 012, no. 020 (E-575), 21 janvier 1988 (1988-01-21) -& JP 62 179110 A (TOSHIBA CORP), 6 août 1987 (1987-08-06)

## Description

La présente invention concerne d'une façon générale la fabrication de substrats semi-conducteurs notamment pour l'industrie électronique, opto-électronique ou optique.

Plus particulièrement, l'invention concerne la réalisation d'un assemblage de deux plaquettes dont au moins l'une est semi-conductrice.

Typiquement, un tel assemblage s'effectue par adhésion moléculaire et, après cet assemblage, va subir un certain nombre d'étapes technologiques de réalisation de circuits ou de composants dans les domaines précités.

Notamment, dans un cycle de fabrication de substrat de type Smart-Cut (marque déposée), mettant en oeuvre une implantation d'espèces gazeuses à une profondeur contrôlée dans une plaquette donneuse massive pour créer une zone de fragilisation, et l'application de contraintes pour réaliser au bout du compte une séparation au niveau de cette zone de fragilisation, la plaquette doit subir, après cette séparation, un certain nombre d'opérations et notamment :
- des étapes de polissage mécanique, mécanochimique, etc. de la plaquette donneuse pour le recyclage de celle-ci,
- des étapes de nettoyage chimique,
- des étapes mettant en jeu des températures plus ou moins élevées, typiquement de 300 à 900°C, telles que des étapes de dépôt d'oxyde, ou à des températures franchement plus élevées, typiquement de 1150°C, pour une oxydation thermique (notamment dans le cas d'une plaquette en carbure de silicium SiC),
- des étapes d'implantation d'espèce(s) gazeuse(s) ;
- une étape de collage par adhésion moléculaire,
- une étape d'application des contraintes de séparation (thermiques et/ou mécaniques et/ou autres).

Le recyclage de la plaquette donneuse amène à prélever en succession dans celle-ci des couches minces, ce qui diminue progressivement l'épaisseur de ladite plaquette. Un tel procédé est décrit dans US-A-6 010 579, Figs. 9-12 et 16-19.

Lorsque cette plaquette donneuse devient excessivement mince, ou alors dans le cas où la plaquette de départ, avant prèlévement de couches, est déjà relativement mince quelle qu'en soit la raison, son utilisation pour des prélèvements subséquents donne lieu aux difficultés suivantes :
- il existe un risque de casse important lors des étapes à dominantes mécaniques telles que les différents transports nécessités par le recyclage, le collage par planarization CMP de l'oxyde de surface, ... ;
- il existe également un risque de casse important lors des traitements thermiques à températures élevées, notamment du fait de températures non homogènes dans la plaquette ;
- la simple manipulation de la plaquette par un opérateur induit également un risque de casse ;
- la plaquette amincie devient particulièrement sensible à certaines étapes technologiques induisant une contrainte importante dans la plaquette, telles que l'étape d'implantation d'espèces gazeuses ou certaines étapes de dépôt ; typiquement, dans le cas de l'implantation d'espèces gazeuses, la plaquette amincie se comporte en adoptant une flèche significative, pour adopter un profil convexe ; une telle flèche compromet gravement l'opération de collage qui impose une planéité satisfaisante des surfaces mises en contact.

Ainsi il existe une épaisseur minimale de plaquette donneuse en deçà de laquelle elle ne peut plus être utilisée, ou donne lieu à de telles casses, ce qui pénalise le processus de fabrication en particulier sur le plan économique.

Notamment, dans le cas d'une plaquette donneuse en SiC, matériau relativement coûteux et fragile, il apparaît qu'une plaquette amincie jusqu'à environ 200 µm devient (dans le cas de plaquettes d'un diamètre standard de 2 pouces, soit environ 5 cm) inutilisable soit parce que les casses au niveau du procédé deviennent trop fréquentes, soit parce que la flèche adoptée suite à l'implantation interdit un bon collage.

Selon un autre exemple, il existe des plaquettes donneuses qui, au départ, présentent nécessairement une faible épaisseur. Ainsi il n'existe pas aujourd'hui sur le marché des plaquettes donneuses de GaN suffisamment épaisses pour ne pas poser les problèmes précités. La pratique actuelle est en effet de réaliser ces plaquettes par la technique d'épitaxie épaisse dite HPVE (acronyme pour l'expression anglo-saxonne « Hybrid Vapor Phase Epitaxy », soit épitaxie hybride en phase vapeur) sur un substrat d'épitaxie (couche germe) qui est éliminé après l'épitaxie. Mais cette technique présente deux inconvénients majeurs : tout d'abord elle ne permet d'obtenir que des plaquettes autoportées d'une épaisseur de l'ordre de 200 à 300 µm au maximum, car si l'on vise des épaisseurs plus grandes, le fait que l'accord de maille avec le substrat germe soit imparfait génère des contraintes excessives ; en outre et surtout, la vitesse de croissance selon cette technique est extrêmement faible (typiquement de 10 à 100 µm par heure), ce qui est un lourd handicap sur le plan du coût de revient.

La présente invention a pour premier objet de pallier ces inconvénients, et de proposer un procédé de prélèvement de couches minces successives dans une plaquette donneuse qui puisse être mis en oeuvre même lorsque le matériau dans lequel on effectue les prélèvement dans la plaquette donneuse atteint des épaisseurs extrêmement faibles.

Ainsi la présente invention propose selon un premier aspect un procédé de report de couches minces successives d'un matériau semi-conducteur d'une plaquette donneuse vers une plaquette receveuse, selon la revendication 1 comprenant les étapes suivantes :
(a) assembler une tranche massive constituée du matériau semi-conducteur avec un support pour former un assemblage mécaniquement stable constituant la plaquette donneuse et comportant une couche donneuse dudit matériau semi-conducteur constituée par la tranche massive et une couche support, constituée par ledit support,
(b) créer dans la couche donneuse une zone de fragilisation à une profondeur contrôlée,
(c) coller la plaquette donneuse sur la plaquette receveuse au niveau de la face libre de la couche donneuse de ladite plaquette donneuse,
(d) effectuer une séparation au niveau de la zone de fragilisation de la couche donneuse, une couche mince du matériau semi-conducteur étant ainsi reportée de la plaquette donneuse sur la plaquette receveuse, et
(e) répéter les opérations (b) à (d) sans que la couche support de la plaquette donneuse ne soit entamée.

Des aspects préférés, mais non limitatifs, du procédé tel que défini ci-dessus sont les suivants :
- l'étape (a) est réalisée par adhésion moléculaire entre des faces polies de la tranche massive et du support.
- l'étape (a) est réalisée par soudure à haute température entre des faces polies de la tranche massive et du support.
- l'étape (b) est réalisée par implantation d'espèces gazeuses.
- l'étape (c) est réalisée par collage par adhésion moléculaire.
- l'étape (d) est réalisée par application de contraintes notamment thermiques et/ou mécaniques.
- les étapes (a) à (d) sont répétées un nombre maximum de fois choisi en fonction de l'épaisseur de la couche donneuse et de la profondeur de la zone de fragilisation.
- le matériau semi-conducteur est un semi-conducteur monocristallin, et le support est choisi dans le groupe comprenant le même semi-conducteur monocristallin de qualité inférieure, le même semi-conducteur polycristallin, et le même semi-conducteur d'un polytype différent.
- le matériau semi-conducteur est choisi dans le groupe comprenant le silicium, le carbure de silicium et les nitrures mono- ou polymétalliques à grand gap.
- la couche donneuse présente une épaisseur de l'ordre de 100 à 300 µm.
- la couche support présente une épaisseur de l'ordre de 100 à 300 µm.
- le matériau semi-conducteur est un nitrure mono- ou polymétallique à grand gap, en particulier du nitrure de gallium.
- la couche support est massive et réalisée dans un matériau compris dans le groupe comprenant le silicium, le nitrure de gallium, le carbure de silicium, le nitrure d'aluminium et le saphir.

Par ailleurs, la technique classique de réalisation de plaquette donneuses massives à partir d'un lingot nécessite typiquement (dans le cas du SiC monocristallin) les étapes opératoires suivantes :
- découpe dans le lingot, à la scie, de tranches d'une épaisseur de l'ordre de 1 mm ;
- polissage grossier de chacune des faces de la tranche, pour éliminer le cristal endommagé par le sciage et obtenir une bonne planéité ;
- polissages successifs de la future face avant (face de prélèvement) pour éliminer le cristal écroui et obtenir une bonne rugosité de surface.

Ainsi ce procédé connu, partant de tranches relativement épaisses, implique des pertes importantes de matière au niveau des étapes successives de polissage, ce qui bien entendu affecte le coût de revient.

Un autre aspect de l'invention vise à permettre de réaliser des plaquettes donneuses avec des pertes moins importantes, et donc de mieux rentabiliser le matériau (ici du SiC monocristallin) de départ.

Des aspects préférés, mais non limitatifs, du procédé sont les suivants :
- la tranche massive est réalisée par sciage à partir d'un lingot, ou bien par épitaxie en couche épaisse sur une couche germe.
- dans ce dernier cas, on prévoit une étape d'élimination de la couche germe.
- le procédé comprend en outre, avant l'étape (a), l'étape suivante :
   (*) réaliser un polissage de la tranche massive seulement sur sa face destinée à venir en contact avec le support.
- le procédé comprend en outre, avant l'étape (a), l'étape suivante :
   (*) réaliser un polissage à un degré déterminé de la face de la tranche massive et de la face du support destinées à venir en contact l'une avec l'autre,
   et en ce que l'étape (a) est effectuée à une température et pendant une durée telles qu'une adhésion moléculaire ou une soudure est réalisée entre la tranche massive et le support.

D'autres aspects, buts et avantages de la présente invention apparaîtront mieux à la lecture de la description détaillée suivante de formes de réalisation préférées de celle-ci, donnée à titre d'exemple non limitatif et faite en référence aux dessins annexés, sur lesquels les figures la-le illustrent schématiquement les étapes d'un procédé de report de couches minces selon l'invention.

On va maintenant décrire dans sa généralité le procédé selon la présente invention.

Avant la mise en oeuvre d'une plaquette donneuse de départ dans un procédé de prélèvement de couches minces successives, cette plaquette donneuse est formée en assemblant une tranche donneuse à un support mécanique. Cet assemblage est réalisé préférentiellement par collage par adhésion moléculaire, en réalisant le cas échéant sur la tranche donneuse et/ou sur le support mécanique des couches d'interface de collage appropriées.

Le support mécanique est choisi pour être compatible avec les traitements imposés par les cycles successifs de prélèvements de couches minces dans la tranche donneuse, notamment en termes de températures.

A cet égard, un facteur important est la relation entre le coefficient de dilatation thermique du matériau de la tranche donneuse et celui du matériau du support mécanique. Ainsi l'on distingue d'abord les « homo-assemblages », c'est-à-dire avec des matériaux pour la couche donneuse et pour la couche support qui présentent des propriétés chimiques et mécaniques voisines. Il s'agira par exemple de couches de matériaux suivantes :
- SiC monocristallin (donneuse) sur SiC polycristallin ou monocristallin de basse qualité (support) ;
- GaN monocristallin (donneuse) sur GaN polycristallin ou monocristallin de basse qualité (support) ;
- Si monocristallin (donneuse) sur Si polycristallin ou monocristallin de basse qualité (support).

Dans ce cas, il n'y a pratiquement pas de limitation quant au budget thermique qui peut être apporté pour la réalisation de la plaquette donneuse, puisque les deux matériaux sont bien accordés thermiquement et il n'y aura pas de perturbation de la couche donneuse par diffusion ou autre.

On distingue ensuite les « hétéro-assemblages », avec des matériaux pour la couche donneuse et pour la couche support qui ont des propriétés mécaniques et/ou chimiques différentes. Il s'agira par exemple des couches de matériaux suivantes :
- SiC monocristallin (donneuse) sur Si (support) ;
- phosphure d'indium InP sur Si ;
- GaN sur Si ; etc.

Dans ce cas, le budget thermique ou la température auquel l'assemblage peut être exposé est plus limité du fait du désaccord thermique pouvant conduire à des déformations ou à des ruptures. Par exemple, dans le cas d'une plaquette donneuse en SiC (couche donneuse) sur Si (couche support), il est difficile de dépasser des températures de l'ordre de 900 à 950°C.

Un autre facteur important est l'épaisseur de l'assemblage support/tranche donneuse réalisé, qui doit être compatible avec les étapes du procédé et permettre de consommer au bout du compte, autant que possible la totalité ou presque de la tranche donneuse.

Une fois le collage réalisé et le cas échéant renforcé par des traitements appropriés, cet assemblage devient une plaquette donneuse à part entière, qui est manipulée au cours des processus successifs de prélèvements de couches minces comme s'il s'agissait d'une plaquette donneuse massive classique, homogène dans toute son épaisseur. Le nombre de prélèvements de couches minces est choisi pour l'essentiel en fonction de l'épaisseur de la couche donneuse et de la profondeur de la zone de fragilisation, de manière à ce que le dernier prélèvement soit effectué sans atteindre la couche support, et sans atteindre d'éventuelles zones de défauts susceptibles d'exister à la transition entre la couche donneuse et la couche support.

Si nécessaire, lorsque l'assemblage est terminé, on peut réaliser un amincissement de la plaquette donneuse au niveau de sa face arrière (côté couche support) pour ajuster l'épaisseur de la plaquette et la rendre compatible avec les étapes technologiques aval et aux éventuelles normes. Par exemple, lorsque la couche support est en silicium, cette étape d'amincissement est réalisable très facilement par rodage mécanique.

### Exemple 1 - cas du SiC

Lorsque la tranche donneuse est constituée de SiC monocristallin, on l'assemble sur un support constitué de préférence par du SiC polycristallin. L'assemblage peut être réalisé par collage direct, ou encore en réalisant sur les faces à assembler des couches intermédiaires par exemple en oxyde de silicium SiO₂.

En termes de polarité, le monocristal de SiC est par exemple collé au support au niveau de sa face Si, tandis que la face C dudit monocristal est la face exposée au niveau de laquelle les prélèvements successifs de couches minces seront effectués, l'inverse étant toutefois possible. On observera ici que cette question de polarité se retrouvera avec tous les matériaux à structure cristalline hexagonale telle que le GaN et l'AlN.

Une étape de polissage initial de cette face, de même que des polissages intermédiaires entre deux prélèvements successifs, sont préférentiellement réalisés.

Du fait que le SiC monocristallin de la tranche donneuse et le SiC polycristallin du support mécanique ont des coefficients de dilatation tous deux voisins de 4,5.10⁻⁶/°K, l'ensemble ainsi constitué peut subir sans dommage toutes les étapes de recyclages, nettoyages chimiques, dépôts, traitements thermiques liés au processus de report de couches minces de type Smart-Cut.

Selon une variante, le support mécanique est en silicium. Dans ce cas, la compatibilité entre le support et la tranche donneuse du point de vue thermique peut s'avérer inférieure, mais reste néanmoins satisfaisante en particulier si l'on limite les températures maximales auxquelles l'ensemble est assujetti au cours des traitements, et plus particulièrement si l'on recourt, pour la réalisation des couches d'oxyde intervenant dans le collage de la couche mince prélevée sur son support, à un dépôt d'oxyde et non pas à une oxydation thermique.

Avantageusement, la fabrication de l'ensemble tranche donneuse/support mécanique met en jeu, toujours dans cet exemple, les étapes suivantes :
- on découpe dans un lingot une tranche d'une épaisseur sensiblement inférieure à l'épaisseur habituelle pour des plaquettes donneuses massives en SiC monocristallin, et typiquement d'une épaisseur de l'ordre de 500 µm au lieu du mm classique ;
- on réalise un polissage au niveau d'une seule des faces de la tranche ;
- on met en contact intime cette face polie avec une face de planéité appropriée d'une plaquette support de SiC polycristallin, de manière à les solidariser par adhésion moléculaire ; la plaquette support est typiquement réalisée par dépôt en couche épaisse de type CVD et ayant une épaisseur par exemple de 200 à 300 µm ; on notera que l'on pourrait également utiliser pour le support un SiC monocristallin de basse qualité (donc peu coûteux), ou encore un SiC d'un polytype différent de celui de la couche donneuse (par exemple SiC 6H pour le support et SiC 4H pour la couche donneuse) ;
- l'ensemble est ensuite exposé à un budget thermique approprié (par exemple à 1100 °C pendant 2 heures) obtenir des forces de liaison souhaitées entre la tranche et la plaquette support ; le degré de polissage des faces en contact est également à prendre en compte pour qu'une adhésion moléculaire satisfaisante soit obtenue dans les conditions précitées ; on obtient ainsi une unique plaquette épaisse combinée SiC monocristallin (couche donneuse) et SiC polycristallin (couche support mécanique) ; en variante, on pourrait également simplement poser les plaquettes l'une sur l'autre et réaliser la liaison par soudure (typiquement à des températures de 2000°C ou davantage), ce qui est toutefois plus contraignant ;
- cette plaquette combinée est alors polie au niveau de la face libre du SiC monocristallin, avec le degré de polissage standard, pour arriver à une couche de SiC monocristallin ne possédant pas de zone écrouie enterrée et présentant une rugosité de surface adéquate.

On réalise ainsi des plaquettes donneuses avec des pertes de matière coûteuse (le SiC monocristallin) très réduites par rapport à la technique des tranches massives citée en introduction, avec en outre un assemblage entre couche donneuse et support très en amont dans la chaîne de fabrication des plaquettes, et donc sans effet sur le procédé de transfert de couches à partir de la plaquette donneuse.

Les économies réalisées sont d'autant plus importantes que le lingot de SiC est plus difficile et/ou plus coûteux à obtenir (cas notamment d'un lingot de SiC semi-isolant à très haute pureté obtenu par le procédé de sublimation par épitaxie épaisse à haute température (connu sous l'appellation HTCVD pour « High Temperature Chemical Vapor Deposition »), ou d'un lingot de SiC à très faible concentration de défauts cristallins intrinsèques tels que dislocations et micropipes).

### Exemple 2 - cas du GaN

Dans le cas de la technique Smart-Cut mise en oeuvre avec une plaquette donneuse en GaN, les différentes étapes mises en oeuvre impliquent des températures généralement bien inférieures à celles rencontrées dans le cas du SiC. Ainsi le problème des coefficients de dilatation thermique respectifs du support et de la plaquette donneuse est moins crucial, ce qui donne plus de souplesse pour le choix du matériau du support.

Dans le présent exemple, une tranche de GaN d'une épaisseur de l'ordre de 100 à 200 µm est collée par adhésion moléculaire sur un support mécanique réalisé par exemple en SiC polycristallin ou monocristallin. Comme pour le cas du SiC, on détermine à l'avance la polarité de la face de la plaquette de GaN qui se situera côté support, et par conséquent la polarité inverse de la face de la plaquette côté libre, c'est-à-dire côté prélèvements.

Ici encore, l'ensemble couche support/couche donneuse de GaN devient une plaquette à part entière utilisée jusqu'à consommation complète ou quasi-complète de la couche donneuse dans les différents cycles d'un procédé de type Smart-Cut.

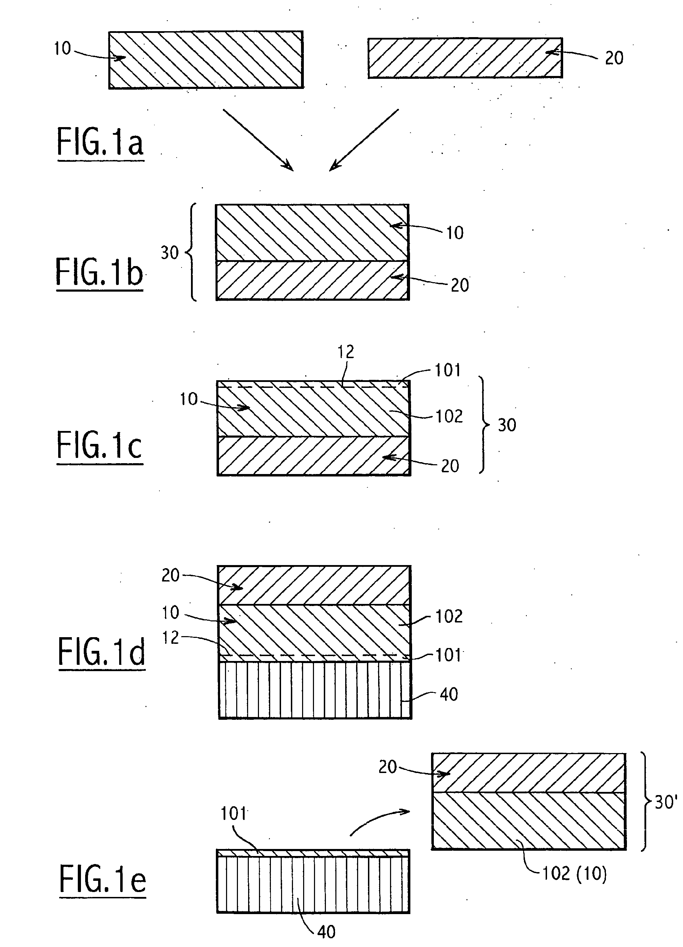

L'invention est illustrée schématiquement sur les figures 1a à 1e des dessins.

Sur la figure 1a, on a illustré une tranche 10 du matériau semi-conducteur qui va constituer les couches minces successivement reportées, et une plaquette support 20.

A la figure 1b, la tranche et la plaquette support sont assemblées comme décrit pour former la plaquette donneuse 30, comprenant la couche donneuse 10 et la couche support 20.

A la figure 1c, une zone de fragilisation enterrée 12 est formée à une certaine profondeur à partir de la surface libre de la couche donneuse 10, cette zone 12 délimitant une couche mince 101 par rapport au reste 102 de la couche donneuse.

A la figure 1d, un collage par adhésion moléculaire est réalisé entre la face libre de la couche donneuse 10 (avec le cas échéant oxydation préalable sur cette face) et une face d'une plaquette receveuse 40 (avec également le cas échéant oxydation préalable sur cette face).

A la figure 1e, une séparation, notamment par contraintes thermiques et/ou mécaniques, est réalisée au niveau de la zone de fragilisation 12, pour obtenir d'une part un ensemble désiré 40, 101, formant typiquement un substrat pour des applications en électronique, optoélectronique ou optique, et d'autre part une plaquette donneuse 30' dont la couche donneuse 10, correspondant essentiellement à la zone 102, a été amincie sensiblement de l'épaisseur de la couche mince transférée 101.

Ces étapes peuvent être reproduites avec la plaquette donneuse 30 sensiblement jusqu'à ce que la couche donneuse 10 ait été entièrement consommée, sans toutefois entamer la couche support 20.

Concrètement, les étapes des figures 1a et 1b peuvent être réalisées chez le fabricant de plaquettes donneuses, tandis que les étapes suivantes peuvent faire partie d'un processus séparé, mis en oeuvre chez le fabricant de substrats composites pour l'industrie électronique, optoélectronique ou optique.

Bien entendu, l'invention s'applique à la réalisation de plaquettes comportant des couches donneuses en d'autres matériaux, tels que le nitrure d'aluminium et plus généralement les nitrures mono- ou poly-métalliques semi-conducteurs, notamment à grand gap, le diamant, etc., ou encore en silicium monocristallin de très haute qualité pour la couche donneuse et de silicium polycristallin ou monocristallin de basse qualité pour le support.

## Revendications

1. Procédé de report de couches minces successives d'un matériau semi-conducteur d'une plaquette donneuse (30) vers une plaquette receveuse (40), comprenant les étapes suivantes :
(a) assembler une tranche massive (10) constituée du matériau semi-conducteur avec un support (20) pour former un assemblage mécaniquement stable constituant la plaquette donneuse (30) et comportant une couche donneuse (10) dudit matériau semi-conducteur constitutuée par la tranche massive et une couche support (20) constituée par ledit support;
(b) créer dans la couche donneuse une zone de fragilisation (12) à une profondeur contrôlée,
(c) coller la plaquette donneuse (30) sur la plaquette receveuse (40) au niveau de la face libre de la couche donneuse de ladite plaquette donneuse,
(d) effectuer une séparation au niveau de la zone de fragilisation de la couche donneuse, une couche mince (101) du matériau semi-conducteur étant ainsi reportée de la plaquette donneuse (30) sur la plaquette receveuse (40), et
(e) répéter les opérations (b) à (d) sans que la couche support de la plaquette donneuse ne soit entamée.

2. Procédé selon la revendication 1, dans lequel l'étape (a) est réalisée par adhésion moléculaire entre des faces polies de la tranche massive et du support.

3. Procédé selon la revendication 1, dans lequel l'étape (a) est réalisée par soudure à haute température entre des faces polies de la tranche massive et du support.

4. Procédé selon la revendication 1 dans lequel l'étape (b) est réalisée par implantation d'espèces gazeuses.

5. Procédé selon la revendication 1, dans lequel l'étape (c) est réalisée par collage par adhésion moléculaire.

6. Procédé selon la revendication 1, dans lequel l'étape (d) est réalisée par application de contraintes notamment thermiques et/ou mécaniques.

7. Procédé selon la revendication 1, dans lequel les étapes (a) à (d) sont répétées un nombre maximum de fois choisi en fonction de l'épaisseur de la couche donneuse et de la profondeur de la zone de fragilisation.

8. Procédé selon la revendication 1, dans lequel le matériau semi-conducteur de la couche donneuse est un semi-conducteur monocristallin, et en ce que le support est choisi dans le groupe comprenant le même semi-conducteur monocristallin de qualité inférieure, le même semi-conducteur polycristallin, et le même semi-conducteur d'un polytype différent.

9. Procédé selon la revendication 8, dans lequel le matériau semi-conducteur est choisi dans le groupe comprenant le silicium, le carbure de silicium et les nitrures mono- ou polymétalliques à grand gap.

10. Procédé selon la revendication 9, dans lequel la couche donneuse présente une épaisseur de l'ordre de l'ordre de 100 à 300 µm.

11. Procédé selon les revendications 9 et 10, dans lequel la couche support présente une épaisseur de l'ordre de 100 à 300 µm.

12. Procédé selon la revendication 1, dans lequel le matériau semi-conducteur de la couche donneuse est un nitrure mono- ou polymétallique à grand gap, en particulier du nitrure de gallium.

13. Procédé selon la revendication 12, dans lequel la couche support est massive et réalisée dans un matériau compris dans le groupe comprenant le silicium, le nitrure de gallium, le carbure de silicium, le nitrure d'aluminium et le saphir.

14. Procédé selon la revendication 1, dans lequel la tranche massive est réalisée par sciage à partir d'un lingot.

15. Procédé selon la revendication 1, dans lequel la tranche massive est réalisée par épitaxie en couche épaisse sur une couche germe.

16. Procédé selon la revendication 16, comprenant une étape d'élimination de la couche germe.

17. Procédé selon la revendication 1, comprenant en outre, avant l'étape (a), l'étape suivante :
* réaliser un polissage de la tranche massive (10) seulement sur sa face destinée à venir en contact avec le support (20).

18. Procédé selon la revendication 1, comprenant en outre, avant l'étape (a), l'étape suivante :
* réaliser un polissage à un degré déterminé de la face de la tranche massive (10) et de la face du support (20) destinées à venir en contact l'une avec l'autre,
et en ce que l'étape (a) est effectuée à une température et pendant une durée telles qu'une adhésion moléculaire ou une soudure est réalisée entre la tranche massive et
le support.

## Claims

1. Method for transferring successive thin layers of a semiconductor material from a donor wafer (30) to a receiving wafer (40), including the following steps:
(a) assembling a heavy slice (10), made of the semiconductor material, and a support (20) for forming a mechanically stable assembly constituting the donor wafer (30) and comprising a donor layer (10) of said semiconductor material made of the heavy slice and a support layer (20) made of said support,
(b) creating a region of weakness (12) in the donor layer at a controlled depth,
(c) bonding the donor wafer (30) to the receiving wafer (40) via the free side of the donor layer of said donor wafer,
(d) effecting a separation in the region of weakness of the donor layer, a thin layer (101) of the semiconductor material thus being transferred from the donor wafer (30) to the receiving wafer (40), and
(e) repeating operations (b) to (d) without the support layer of the donor wafer being breached.

2. Method according to molecular adhesion bonding between polished faces of the heavy slice and of the support.

3. Method according to claim 1, wherein step (a) is carried out by high-temperature welding between polished faces of the heavy slice and of the support.

4. Method according to claim 1, wherein step (b) is carried out by implanting gaseous species.

5. Method according to claim 1, wherein step (c) is carried out by molecular adhesion bonding.

6. Method according to claim 1, wherein step (d) is carried out by applying stresses, especially thermal and/or mechanical stresses.

7. Method according to claim 1, wherein steps (a) to (d) are repeated a chosen maximum number of times depending on the thickness of the donor layer and on the depth of the region of weakness.

8. Method according to claim 1, wherein the semiconductor material of the donor layer is a single-crystal semiconductor and the support is chosen from the group comprising the same semiconductor as a single crystal of inferior quality, the same semiconductor in polycrystalline form and the same semiconductor as a different polytype.

9. Method according to claim 8, wherein the semiconductor material is chosen from the group comprising silicon, silicon carbide and large-gap monometallic or polymetallic nitrides.

10. Method according to claim 9, wherein the donor layer has a thickness of around 100 to 300 µm.

11. Method according to either of claims 9 and 10, wherein the support layer has a thickness of around 100 to 300 µm.

12. Method according to claim 1, wherein the semiconductor material of the donor layer is a large-gap monometallic or polymetallic nitride, in particular gallium nitride.

13. Method according to claim 12, wherein the support layer is a heavy layer and produced from a material taken from the group comprising silicon, gallium nitride, silicon carbide, aluminium nitride and sapphire.

14. Method according to claim 1, wherein the heavy slice is produced by sawing an ingot.

15. Method according to claim 1, wherein the heavy slice is produced by thick-film epitaxy on a seed layer.

16. Method according to claim 15 including a step for removing the seed layer.

17. Method according to claim 1 further including before step (a), the following step:
* polishing the heavy slice (10) only on the face thereof intended to come into contact with the support (20).

18. Method according to claim 1 further including before step (a), the following step:
* polishing, to a defined degree, the face of the heavy slice (10) and the face of the support (20) which are intended to come into contact with each other,
and in that step (a) is carried out at a temperature and for a time such that molecular adhesion or welding is achieved between the heavy slice and the support.

## Patentansprüche

1. Verfahren zum wiederholten Übertragen von Dünnschichten aus einem Halbleitermaterial von einer Geberplatte (30) auf eine Empfängerplatte (40), das die folgenden Schritte umfasst:
(a) Verbinden einer massiven Scheibe (10), die aus dem Halbleitermaterial besteht, mit einem Träger (20), um eine mechanisch stabile Einheit zu bilden, die die Geberplatte (30) bildet und die eine Geberschicht (10) aus dem Halbleitermaterial, die aus der massiven Scheibe besteht, und eine Trägerschicht (20), die aus dem Träger besteht, umfasst;
(b) Erzeugen einer Schwächungszone (12) in der Geberschicht in einer einstellbaren Tiefe;
(c) Aufbringen der Geberplatte (30) auf die Empfängerplatte (40) im Bereich der freien Seite der Geberschicht der Geberplatte,
(d) Ausführen einer Trennung im Bereich der Schwächungszone der Geberschicht, wobei hierdurch eine Dünnschicht (101) aus dem Halbleitermaterial von der Geberplatte (30) auf die Empfängerplatte (40) übertragen wird, und
(e) Wiederholen der Vorgänge (b) bis (d), ohne dass dabei die Trägerschicht der Geberplatte angegriffen wird.

2. Verfahren nach Anspruch 1, bei dem der Schritt (a) durch molekulare Adhäsion zwischen polierten Flächen der massiven Scheibe und des Trägers realisiert wird.

3. Verfahren nach Anspruch 1, bei dem der Schritt (a) durch Verschweißen bei hohen Temperaturen zwischen polierten Flächen der massiven Scheibe und des Trägers realisiert wird.

4. Verfahren nach Anspruch 1, bei dem der Schritt (b) durch Implantation von gasförmigen Atomen realisiert wird.

5. Verfahren nach Anspruch 1, bei dem der Schritt (c) durch eine Verbindung durch molekulare Adhäsion realisiert wird.

6. Verfahren nach Anspruch 1, bei dem der Schritt (d) durch die Anwendung von insbesondere thermischen und/oder mechanischen Einwirkungen realisiert wird.

7. Verfahren nach Anspruch 1, bei dem die Schritte (a) bis (d) in einer maximalen Anzahl wiederholt werden, die in Abhängigkeit von der Dicke der Geberschicht und der Tiefe der Schwächungszone gewählt wird.

8. Verfahren nach Anspruch 1, bei dem das Halbleitermaterial der Geberschicht ein monokristalliner Halbleiter ist, wobei der Träger aus der Gruppe gewählt ist, die denselben monokristallinen Halbleiter mit minderer Qualität, denselben Halbleiter in polykristalliner Form und denselben Halbleiter aus einem verschiedenen Polytyp umfasst.

9. Verfahren nach Anspruch 8, bei dem das Halbleitermaterial aus der folgenden Gruppe gewählt ist: Silizium, Siliziumcarbid und die mono- oder polymetallischen Nitride mit großer Bandlücke.

10. Verfahren nach Anspruch 9, bei dem die Geberschicht eine Dicke von etwa 100 bis 300 µm hat.

11. Verfahren nach den Ansprüchen 9 und 10, bei dem die Trägerschicht eine Dicke von etwa 100 bis 300 µm hat.

12. Verfahren nach Anspruch 1, bei dem das Halbleitermaterial der Geberschicht ein mono- oder polymetallisches Nitrid mit großer Bandlücke und insbesondere Galliumnitrid ist.

13. Verfahren nach Anspruch 12, bei dem die Trägerschicht massiv und aus einem Material hergestellt ist, das aus der folgenden Gruppe gewählt ist:
Silizium, Galliumnitrid, Siliziumcarbid, Aluminiumnitrid und Saphir.

14. Verfahren nach Anspruch 1, bei dem die massive Scheibe, ausgehend von einem Block, durch Sägen hergestellt wird.

15. Verfahren nach Anspruch 1, bei dem die massive Scheibe durch das Aufwachsen einer dicken Schicht auf einer Keimschicht hergestellt wird.

16. Verfahren nach Anspruch 15, das einen Schritt zum Entfernen der Keimschicht umfasst.

17. Verfahren nach Anspruch 1, das außerdem vor dem Schritt (a) den folgenden Schritt umfasst:
Polieren der massiven Scheibe (10), und dies nur auf der Fläche, die dafür vorgesehen ist, in Kontakt mit dem Träger (20) zu kommen.

18. Verfahren nach Anspruch 1, das außerdem vor dem Schritt (a) den folgenden Schritt umfasst:
Ausführen eines Poliervorgangs bis zu einem bestimmten Grade, und dies für die Fläche der massiven Scheibe (10) und die Fläche des Trägers (20), die dafür vorgesehen sind, miteinander in Kontakt zu kommen,
wobei der Schritt (a) bei einer solchen Temperatur und über eine solche Dauer ausgeführt wird, dass zwischen der massiven Scheibe und dem Träger eine molekulare Adhäsion oder eine Verschweißung zustande kommt.
